Europäisches Patentamt

(19) European Patent Office

Office européen des brevets

(11) Numéro de publication: **0 267 820**
**B1**

(12) **FASCICULE DE BREVET EUROPEEN**

(45) Date de publication du fascicule du brevet:
20.06.90

(21) Numéro de dépôt: 87402257.7

(22) Date de dépôt: 09.10.87

(51) Int. Cl.⁵: **H01J 37/30**, H01J 37/317,
H01J 37/04

(54) **Dispositif d'optique électronique, d'illumination et de limitation d'ouverture variables, et son application à un système de lithographie par faisceau d'électrons.**

(30) Priorité: 14.10.86 FR 8614261

(43) Date de publication de la demande:
18.05.88 Bulletin 88/20

(45) Mention de la délivrance du brevet:
20.06.90 Bulletin 90/25

(84) Etats contractants désignés:
GB NL

(56) Documents cités:
DE-A- 2 702 446

PATENT ABSTRACTS OF JAPAN,
vol. 6, no. 136 (E-120)[1014], 23 juillet 1982; &
JP-A-57 62 531 (FUJITSU K.K.) 15-04-1982
PATENT ABSTRACTS OF JAPAN,
vol. 10, no. 240 (E-429)[2296], 19 août 1986; &
JP-A-61 71 539 (INTERNATL PRECISION
INC) 12-04-1986
IBM TECHNICAL DISCLOSURE BULLETIN,
vol. 27, no. 2, juillet 1984, pages 1224-1225, New York,
US; M. ESSIG: "Critical Koehler Illumination concept for
electron probe systems"

(73) Titulaire: THOMSON-CSF, 51, Esplanade du Général de
Gaulle, F-92800 Puteaux(FR)

(72) Inventeur: De Chambost, Emmanuel, THOMSON-CSF
SCPI 19, avenue de Messine, F-75008 Paris(FR)
Inventeur: Sonrier, Michel, THOMSON-CSF
SCPI 19, avenue de Messine, F-75008 Paris(FR)

(74) Mandataire: Turlèque, Clotilde et al, THOMSON-CSF
SCPI, F-92045 PARIS LA DEFENSE CEDEX 67(FR)

ACTORUM AG

## Description

L'invention se rapporte au domaine de l'optique électronique, et plus particulièrement aux systèmes optiques de lithographie par faisceau d'électrons.

En optique électronique, il est fréquent d'avoir à projeter sur un plan appelé "plan-image", l'image d'un objet matérialisé dans un plan du système d'optique électronique conjugué avec le plan-image. En tout point de l'image, les trajectoires incidentes sont inscrites dans un cône de demi-ouverture "α". Cet angle "α" est à mettre en relation avec la partie utilisée de la dernière lentille appelée "objectif" qui ne peut dépasser certaines limites sous peine de voir les aberrations excéder la précision requise. Citons notamment :
- L'aberration sphérique, proportionnelle au cube de l'angle "α".
- L'aberration chromatique, proportionnelle à l'angle "α".

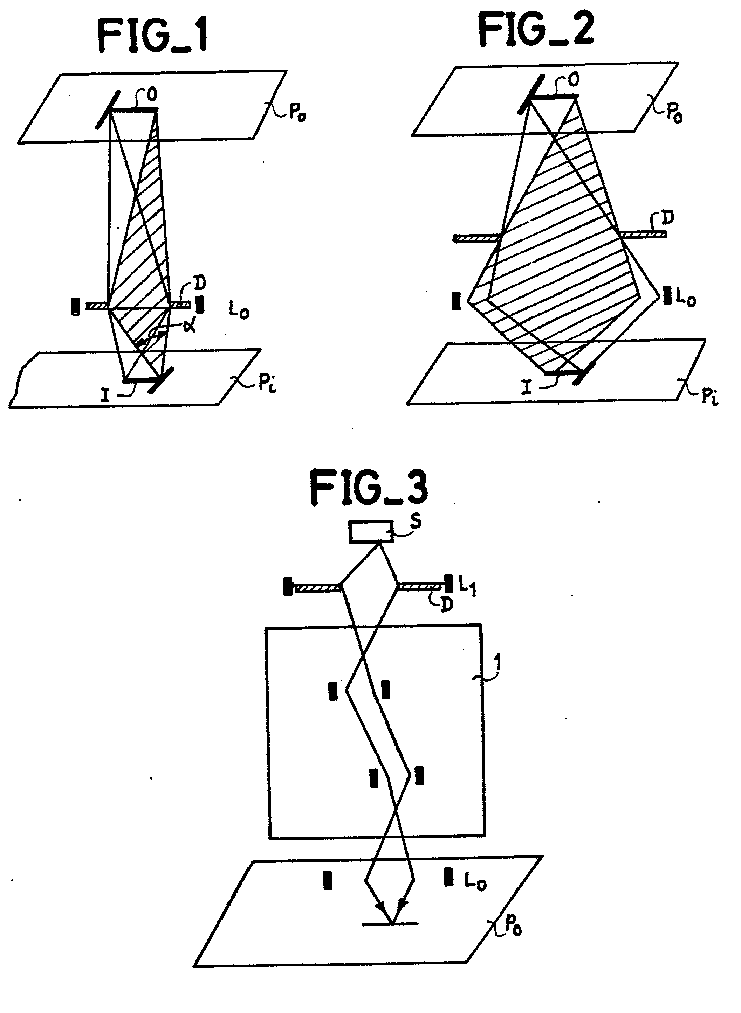

Pour limiter l'angle "α", la solution la plus classique, notamment dans les appareils de microscopie électronique, consiste à disposer un diaphragme D dans le plan principal de l'objectif LO comme représenté sur la figure 1, l'objectif formant dans le plan image Pi une image de l'objet situé dans le plan objet PO.

Une solution voisine consiste à disposer le diaphragme D entre le plan objet ou le dernier plan conjugué du plan image et le plan principal de l'objectif, comme représenté sur la figure 2. Cette solution peut être retenue lorsque la pénombre déterminée dans le plan principal de l'objectif par le diaphragme et l'avant-dernière image est négligeable devant l'ombre du diaphragme dans le plan principal. Son avantage est de laisser la place à un système de déviation situé entre le diaphragme et l'objectif, qui ne devra pas nécessairement avoir un point de pivot dans le plan du diaphragme. Cette solution est souvent retenue pour des systèmes de lithographie par faisceau d'électrons.

Une autre solution décrite dans la demande de brevet français 81 17846, et représentée sur la figure 3, consiste à disposer le diaphragme de limitation d'ouverture D le plus près possible de la source S par exemple près d'une première lentille L1 et de concevoir le système d'optique électronique, 1, de telle sorte que ce diaphragme soit conjugué avec le plan principal de l'objectif LO. Cette solution a l'avantage de limiter dès le début des trajectoires le courant des particules chargées et par là-même de réduire au maximum des effets parasites de nature coulombienne connus sous le nom d'effet "Boersch" ou d'effet de charge d'espace. Dans le brevet cité ci-dessus, il est expliqué que cette solution peut être particulièrement intéressante pour des systèmes de lithographie à faisceau d'électrons dits "rectangulaires variables" ou encore à "faisceau formé".

Dans les trois cas décrits ci-dessus, il existe une relation biunivoque linéaire entre le diamètre du diaphragme matérialisé dans le système et l'angle "α". De cette façon, si on veut faire varier l'angle "α", parce que d'une utilisation à l'autre, la précision requise n'est pas la même, il est nécessaire de changer le diaphragme, soit en démontant le système, soit en utilisant un dispositif mécanique à plusieurs positions, chaque position correspondant à un diaphragme différent disposé sur la trajectoire du faisceau. Un tel dispositif mécanique a deux inconvénients :
- la complexité mécanique introduite dans le système.
- la limitation du nombre de valeurs qui peuvent être attribuées à l'angle "α", souvent 3 valeurs seulement.

Par ailleurs, dans de tels systèmes, il est nécessaire de déterminer l'illumination de l'objet, à partir de la source.

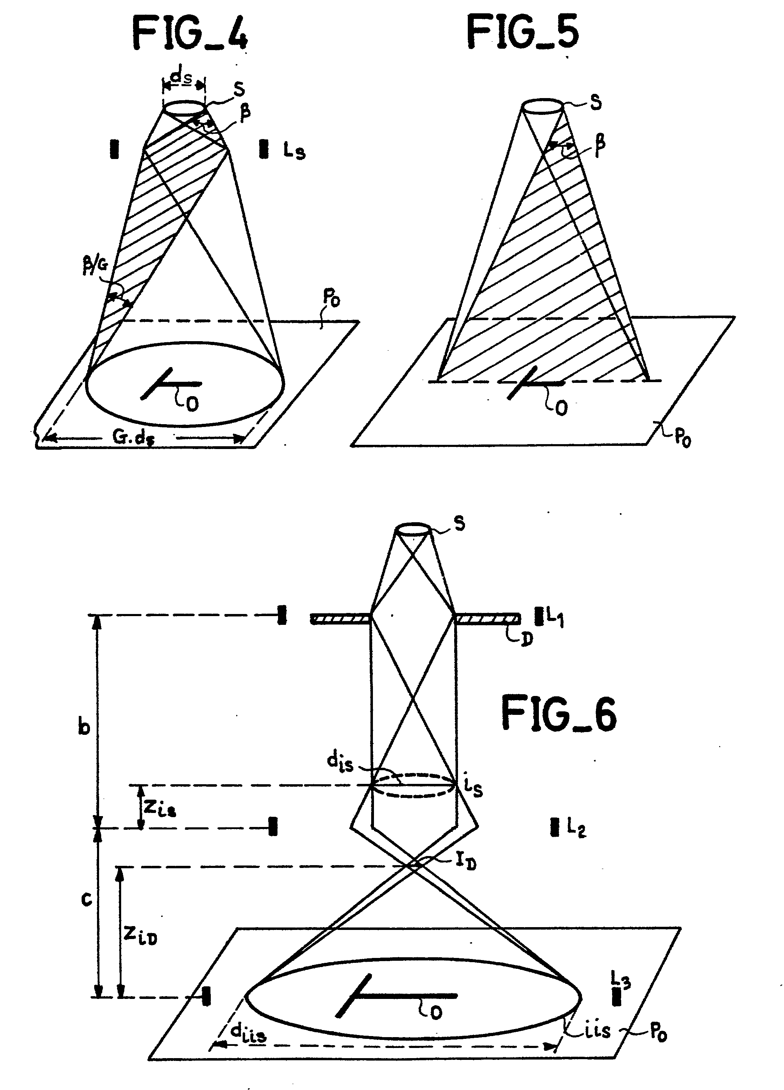

Etant donnée une source de diamètre $d_s$ qui émet dans un cône de demi-ouverture β, il est classique d'utiliser un système de lentilles électroniques, $L_s$, pour projeter sur l'objet à illuminer une image de la source dont le diamètre sera $G \times d_s$, pour une ouverture du faisceau de β/G ; on parle alors d'illumination critique. Ce mode d'illumination est représenté sur la figure 4.

Il est également classique d'utiliser un système de lentilles électroniques pour qu'au plan de l'objet à illuminer, l'image de la source soit rejetée à l'infini, et qu'ainsi, on projette sur l'objet une image du diagramme angulaire de la source. On parle alors d'illumination de KOHLER. Ce mode d'illumination est représenté sur la figure 5.

Rien n'interdit évidemment de choisir des solutions intermédiaires entre ces deux illuminations typiques.

L'invention a pour objet un dispositif d'optique électronique dans lequel l'illumination et la limitation d'ouverture sont variables sans opération mécanique telle qu'un changement de diaphragme.

L'invention a également pour objet un dispositif d'optique électronique destiné, entre-autres, à l'illumination d'un objet à partir d'une source et à la projection d'une image de cet objet sur un "plan-image", dans lequel l'ouverture du faisceau doit être limitée à un angle "α". Un jeu de trois lentilles est utilisé à la fois pour régler l'illumination de l'objet et pour faire varier par des moyens purement électroniques l'ouverture "α" de façon continue, sans dérégler les autres fonctions du système d'optique électronique.

Selon l'invention un dispositif d'optique électronique, est caractérisé en ce qu'il comporte, entre une source de particules et un objet situé dans un plan objet et dont une image doit être projetée dans un plan image, un jeu de trois lentilles électroniques à focales commandables électroniquement, la première étant située aussi près que possible de la source et associée à un diaphragme de limitation d'ouverture situé dans un voisinage de son plan principal, les focales de ces trois lentilles étant commandées pour donner à la section du faisceau de particules dans le plan objet, une valeur déterminant l'illumina tion souhaitée et à l'image du diaphragme un diamètre et une position déterminant l'ouverture souhaitée pour le faisceau incident sur l'objet.

L'invention a également pour objet l'application de ce dispositif à un système de lithographie par faisceau d'électrons.

L'invention sera mieux comprise et d'autres caractéristiques apparaîtront à l'aide de la description qui suit en référence aux figures annexées.

Les figures 1 à 3 représentent des moyens connus de limitation de l'ouverture du faisceau électronique.

Les figurs 4 et 5 sont deux exemples connus de moyens d'illumination.

La figure 6 représente schématiquement le dispositif d'optique électronique selon l'invention.

La figure 7 représente une application du dispositif selon l'invention dans laquelle l'image à projeter est une image composite de deux objets.

La figure 8 représente les moyens de réglage des distances focales des lentilles du dispositif selon l'invention.

Le dispositif selon l'invention est un dispositif "d'optique" électronique, c'est-à-dire un dispositif comportant des "lentilles" électrostatiques ou magnétiques de concentration d'un faisceau de particules chargées, ainsi que des déflecteurs magnétiques et des diaphragmes. Sur les figures, les lentilles ont été représentées, pour plus de simplicité, comme on les représente habituellement en optique.

Le dispositif d'optique électronique selon l'invention, représenté sur la figure 6 comporte un jeu de trois lentilles $L_1$, $L_2$, $L_3$ et un diaphragme D. Ce diaphragme D est situé à proximité du plan principal de la première lentille $L_1$. Le dispositif est fait pour être inséré entre une source de particules S et un "objet" à illuminer O. La première lentille $L_1$ se trouve le plus près possible de la source et le plan principal de la troisième lentille $L_3$ se trouve à proximité du plan de l'objet, O, $P_O$.

Dans le cas idéal où le diaphragme D est effectivement situé au plan principal de la lentille $L_1$ et où l'objet à illuminer O est effectivement au plan principal de la lentille $L_3$, avant la prise en compte de $L_3$, la définition des images respectives de la source et du diaphragme produites par $L_1$ et $L_2$ rendent entièrement compte de l'action de ces deux lentilles. Ainsi, en utilisant les hypothèses relatives aux lentilles minces acceptables ici, et en supposant que b est la distance entre les deux lentilles $L_1$ et $L_2$, et c est la distance entre les deux lentilles $L_2$ et $L_3$ :

La position de l'image ID du diaphragme D par rapport au plan objet, $Z_{ID}$ est donnée par :

(1) $1/b + 1/(c - Z_{ID}) = 1/F_2$, où $F_2$ est la distance focale de $L_2$.

Le diamètre $d_{ID}$ de l'image du diaphragme est donné par

(2) $d_{ID} = d_D \cdot (c - Z_{ID})/b$, où $d_D$ désigne le diamètre du diaphragme.

De ces deux grandeurs, on peut déduire l'ouverture du faisceau, $\theta$, au plan de l'objet à illuminer :

(3) $\theta = d_{ID}/Z_{ID}$, expression qui peut être évaluée à partir des relations (1) et (2) précédentes.

Les trois relations (1), (2), (3) établissent une relation biunivoque $\theta = f(F_2)$.

Le réglage de la focale $F_3$ de la lentille $L_3$ est alors le moyen de faire varier la position $Z_{iiD}$ du diaphragme virtuel suivant la relation :

(4) $Z_{iiD} = -1(1/F_3 - 1/Z_{ID})$

De la même façon, en appliquant les mêmes formules classiques des lentilles minces, on peut déduire successivement la position $Z_{is}$ et le diamètre $d_{is}$ de l'image de la source donnée par $L_1$, puis le diamètre $d_{iis}$ de l'image de cette image donnée par $L_2$, au plan $P_O$.

La position $Z_{IS}$ de la première image $I_S$ de la source $I_S$ par rapport à la lentille $L_2$, est donné par :

$$(5) \quad \frac{1}{a} + \frac{1}{b-Z_{is}} = \frac{1}{F_1}$$

La position c de la deuxième image de la source $i_{is}$, par rapport à la lentille $L_2$ est reliée à la focale $F_2$ de $L_2$ par :

3

$$(6) \quad \frac{1}{Z_{is}} = \frac{1}{F_2} - \frac{1}{c}$$

Les deux relations (5) et (6) déterminent le diamètre $d_{iis}$ de la deuxième image de la source :

$$(7) \quad d_{iis} = d_s \frac{b - Z_{is}}{a} + \frac{c}{Z_{is}}$$

Les trois relations (5), (6) et (7) établissent une relation biunivoque en fonction de $F_1$ :

$d_{iis} = f(F_1)$

Les positions et les diamètres des images réelles ou virtuelles de la source et du diaphragme données par les lentilles $L_1$ et $L_2$ rendent compte de l'illumination de l'objet, ainsi qu'on peut le voir sur la figure 6.

En résumé, $L_2$ et $L_3$ peuvent être utilisées pour déterminer les caractéristiques de l'images du diaphragme, et, $L_2$ et $L_3$ étant fixées, $L_1$ peut être utilisée pour déterminer les caractéristiques de l'image de la source et donc de la section du faisceau au niveau de l'objet.

Dans le cas général où le diaphragme n'est pas exactement au plan principal de $L_1$, mais à son voisinage, et où le plan principal de $L_3$ n'est pas exactement confondu avec le plan de l'objet, les trois lentilles $L_1$, $L_2$ et $L_3$ donnent les trois degrés de liberté nécessaires pour régler électroniquement la section du faisceau au plan de l'objet, le diamètre et la position du diaphragme virtuel ID, image du diaphragme réel, déterminant l'ouverture du faisceau.

Il peut être nécessaire, en microlithographie notamment, d'utiliser des systèmes d'optique électronique où ce n'est pas un seul objet dont l'image est projetée sur un plan-cible, mais l'image composite de deux objets 01 et 02. Ceci peut être obtenu en formant l'image d'un premier objet 01 sur le plan d'un deuxième objet 02, un système optique projetant ensuite l'image composite des deux objets sur un plan cible Pi. Le cas le plus simple est celui où les deux objets sont des diaphragmes d'ouverture carrée. Dans ce cas, l'image composite sera généralement un rectangle, et ce rectangle aura des dimensions variables si des moyens de déflexion sont disposés entre les deux plans objet. La description de tels systèmes est par exemple donnée dans :
- l'article de J. Trotel, "Dynamic beam shaping" J. Vac.Sci.Technol., 15(3) May/June 1978, pages 872-873
- dans le compte rendu de la conférence sur la microlithographie des 30 sept-2 Oct. par J. Trotel, "Electron beam direct writing lithographic system"
- et dans un article de E. de Chambost et al, "Fast electron pattern generator - High resolution" J.Vac.Technol. B4(1), Jan/Feb 1986 pages 78-82.

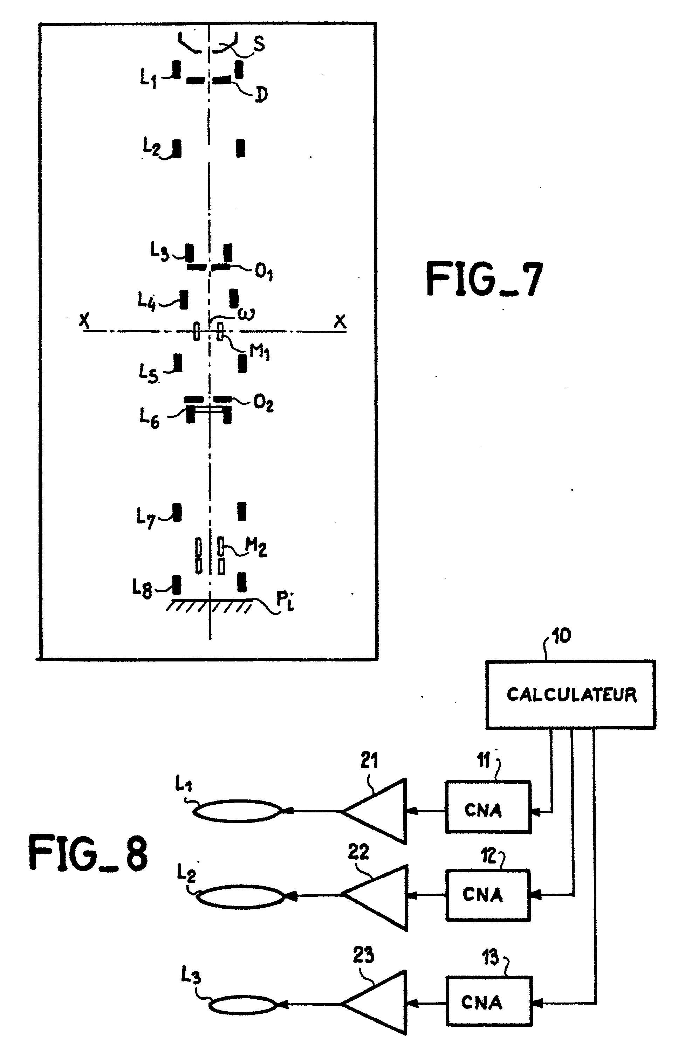

La figure 7 représente un dispositif d'optique électronique selon l'invention, particulièrement adapté à la projection dans le plan Pi, d'une image composite de deux objets, 01 et 02.

Sur la figure 7, $L_1$, $L_2$ et $L_3$ sont les mêmes lentilles que celles décrites ci-desus et sont disposées comme indiqué. Deux stencils gravés sont les deux objets 01 et 02 dont il est question ci-dessus ; ce sont des diaphragmes dont l'ouverture est carrée. $L_4$ et $L_5$ sont deux lentilles identiques, associées en doublet, dont la fonction est de former l'image du stencil 01 au plan du stencil 02. Au centre de ce doublet, symétrique par rapport à l'axe XX, un déviateur magnétique M1 permet de produire au niveau du plan de 02 un rectangle composite variable. Deux lentilles $L_7$ et $L_8$ forment un système de réduction de ce rectangle composite variable. Une lentille supplémentaire $L_6$ est utilisée pour rendre conjugués le plan du centre de déflexion $\omega$ du déviateur et le plan principal de la dernière lentille, $L_8$, de façon que le faisceau reste immobile dans la lentille objectif $L_8$ lorsque le déviateur $M_1$ est activé pour faire varier les dimensions du rectangle composite. Un double déflecteur $M_2$ permet de faire varier les coordonnées du motif projeté dans le plan image Pi.

Dans cette application particulièrement intéressante de l'invention, la focale de $L_3$ est ajustée pour que le centre de déflexion $\omega$ du déviateur $M_1$ soit conjugué avec le diaphragme de limitation d'ouverture D. Du fait que le centre de déflexion est également conjugué avec le plan principal de $L_8$, l'image du diaphragme de limitation d'ouverture se forme bien au plan principal de $L_8$, et toute variation de la distance focale de $L_2$ se traduit par une variation du diamètre du faisceau dans le plan principal de la lentille $L_8$, ce qui est le but recherché. Cependant, pour que la variation du diamètre de l'image du diaphragme ne s'accompagne pas d'une défocalisation de l'image de ce diaphragme, il est nécessaire d'ajuster la focale de la lentille $L_3$ pour que le plan du diaphragme d'ouverture reste bien conjugué avec le plan du déviateur de modulation $M_1$, et donc avec le plan principal de $L_8$.

Pour ce système particulier, comme pour tout autre système selon l'invention comportant le jeu de trois lentilles et le diphragme définis ci-dessus, la relation entre la distance focale de la deuxième lentille $L_2$, le grandissement de l'image ID du diaphragme D et la correction nécessaire qui doit être apportée sur la distance focale de $L_3$ peut être tabulée et mise en mémoire dans un calculateur. De la même façon, il est aussi possible de réajuster la focale de la première lentille $L_1$ chaque fois que l'on fait varier $L_2$. Un extrait d'un tableau des valeurs qui doivent être mises en mémoire dans le calculateur pour cet exemple particulier est indiqué ci-après.

| Valeur désirée de $d_{lD}$ le plan de $L_8$ (mm) | Distance focale de $L_2$ (mm) | Distance focale de $L_1$ (mm) | Distance focale de $L_3$ (mm) |
|---|---|---|---|
| 400 | 10,33 | 10,3386 | 106 |
| 568 | 13 | 13,1 | 100 |

Il est entendu que l'homme de l'art connaît les relations entre les distances focales des lentilles et les courants d'excitation des lentilles s'il s'agit de lentilles magnétiques ou les tensions appliquées s'il s'agit de lentilles électrostatiques, à appliquer aux lentilles agissant sur le faisceau de particules.

Pour un mode de réalisaton dans lequel les lentilles seraient des lentilles magnétiques (respectivement des lentilles électrostatiques), le dispositif selon l'invention serait celui proposé sur la figure 8 où chaque valeur numérique issue de la mémoire d'un calculateur 10 est transmise à un convertisseur numérique-analogique 11, 12, 13 respectivement, qui commande via un amplificateur, 21, 22, et 23 respectivement, le courant d'excitation (ou la tension) appliqué aux lentilles $L_1$, $L_2$ et $L_3$.

## Revendications

1. Dispositif d'optique électronique comportant, entre une source de particules (S) et un objet (O) situé dans un plan objet (PO) et dont une image doit être projetée dans un plan image (Pi), un jeu de trois lentilles électroniques ($L_1$, $L_2$, $L_3$) à focales commandables électroniquement, la première étant située aussi près que possible de la source et associée à un diaphragme de limitation d'ouverture (D) situé dans un voisinage de son plan principal, les focales de ces trois lentilles étant commandées pour donner à la section du faisceau de particules dans le plan objet, une valeur déterminant l'illumination souhaitée et à l'image du diaphragme un diamètre et une position déterminant l'ouverture souhaitée pour le faisceau incident sur l'objet.

2. Dispositif selon la revendication 1, caractérisé en ce que les lentilles sont des lentilles magnétiques et dans lequel les commandes électroniques sont appliquées aux courants d'excitation des lentilles magnétiques.

3. Dispositif selon la revendication 1, caractérisé en ce que les lentilles sont des lentilles électrostatiques et dans lequel les commandes électroniques sont appliquées aux tensions de commande des lentilles.

4. Dispositif selon l'une quelconque des revendications précédentes, caractérisé en ce que le plan principal de la troisième lentille est confondu avec le plan de l'objet.

5. Application du dispositif d'optique électronique selon l'une des revendications précédentes à un système de lithographie par faisceau d'électrons.

## Patentansprüche

1. Elektronenoptische Vorrichtung, bei der zwischen einer Partikelquelle (S) und einem in einer Objektebene (PO) liegenden Gegenstand (O), dessen Bild in eine Bildebene (Pi) projiziert werden soll, ein Satz von drei elektronischen Linsen ($L_1$, $L_2$, $L_3$) angeordnet ist, deren Brennweiten elektronisch gesteuert werden können und von denen die erste so nahe wie möglich bei der Quelle liegt und einer in der Nähe ihrer Hauptebene liegenden Blende (D) zur Öffnungsbegrenzung zugeordnet ist, wobei die Brennweiten dieser drei Linsen so gesteuert werden, daß der Querschnitt des Partikelstrahls in der Objektebene einen die gewünschte Beleuchtung bestimmenden Wert annimmt und daß das Bild der Blende einen Durchmesser und eine Lage bekommt, die die für den auf den Gegenstand fallenden Strahl gewünschte Öffnung bestimmen.

2. Vorrichtung nach Anspruch 1, dadurch gekennzeichnet, daß die Linsen magnetische Linsen sind und die elektronischen Steuerungen auf die Erregerströme der magnetischen Linsen einwirken.

3. Vorrichtung nach Anspruch 1, dadurch gekennzeichnet, daß die Linsen elektrostatische Linsen sind und die elektronischen Steuerungen auf die Steuerspannungen der Linsen einwirken.

4. Vorrichtung nach einem beliebigen der vorhergehenden Ansprüche, dadurch gekennzeichnet, daß die Hauptebene der dritten Linse mit der Objektebene zusammenfällt.

5. Anwendung der elektronenoptischen Vorrichtung nach einem der vorhergehenden Ansprüche auf ein Elektronenstrahl-Lithographiesystem.

## Claims

1. An electronic optical device comprising, between a particle source (S) and an object which is situated in an object plane (PO) and whose image is intended to be projected into an image plane (Pi), a set of three electronic lenses ($L_1$, $L_2$, $L_3$) whose focal lengths may be controlled electronically, the first lens being located as close as possible to the source and being associated to a diaphragm (D) for restricting the aperture, this diaphragm being situated in the vicinity of the main plane of said lens, the focal lengths of these three lenses being controlled such that the cross-section of the particle beam in the object plane is adjusted to determine the desired illumination and that the image of the diaphragm presents such a diameter and such a position so as to determine the desired aperture for the beam falling on the object.

2. A device according to claim 1, characterized in that the lenses are magnetic lenses and that the electronic control Signals are applied to the magnetic lens excitation currents.

3. A device according to claim 1, characterized in that the lenses are electrostatic lenses and that the electronic control signals are applied to the lens control voltages.

4. A device according to any one of the preceding claims, characterized in that the main plane of the third lens coincides with the object plane.

5. The application of the electronic optical device according to one of the preceding claims to an electron beam lithographic system.

FIG_1

FIG_2

FIG_3

FIG_4

FIG_5

FIG_6

FIG_7

FIG_8

CALCULATEUR

CNA

CNA

CNA